Europäisches Patentamt

European Patent Office

Office européen des brevets

(19)

(11) Publication number: **0 147 151 B1**

# EUROPEAN PATENT SPECIFICATION

(12)

(45) Date of publication of patent specification: **21.08.91**

(51) Int. Cl.⁵: **H01L 27/06,** H01L 27/12, H01L 21/82, //G11C11/34

(21) Application number: **84308803.0**

(22) Date of filing: **17.12.84**

(54) Semiconductor memory with stacked structure.

(30) Priority: **19.12.83 JP 237776/83**

(43) Date of publication of application:
**03.07.85 Bulletin 85/27**

(45) Publication of the grant of the patent:
**21.08.91 Bulletin 91/34**

(84) Designated Contracting States:
**DE FR GB**

(56) References cited:
**EP-A- 0 096 734**
**DE-A- 3 043 913**
**US-A- 4 084 108**

(73) Proprietor: **HITACHI, LTD.**
**6, Kanda Surugadai 4-chome**
**Chiyoda-ku, Tokyo 100(JP)**

Proprietor: **HITACHI MICROCOMPUTER ENGI-NEERING LTD.**
**1479, Josuihon-cho**
**Kodaira-shi Tokyo(JP)**

(72) Inventor: **Kume, Hitoshi**
**1-33-7, Nishikubo**
**Musashino-shi Tokyo(JP)**
Inventor: **Hagiwara, Takaaki**
**2196-479, Hirai Honodemachi**
**Nishitama-gun Tokyo(JP)**
Inventor: **Horiuchi, Masatada**
**5-13-7, Minamichi Nukui**
**Koganei-shi Tokyo(JP)**
Inventor: **Kaga, Toru**
**3-29-19, Buzo**
**Urawa-shi Saitama-ken(JP)**
Inventor: **Igura, Yasuo**
**4-14-6, Nishikoigakubo**
**Kokubunji-shi Tokyo(JP)**
Inventor: **Shimizu, Akihiro**
**2-4-40, Mure**
**Mitaka-shi Tokyo(JP)**

(74) Representative: **Calderbank, Thomas Roger et al**
**MEWBURN ELLIS & CO. 2/3 Cursitor Street**
**London EC4A 1BQ(GB)**

## Description

The present invention relates to a semiconductor memory.

Two types of random access memory cell have been used for dynamic operation.

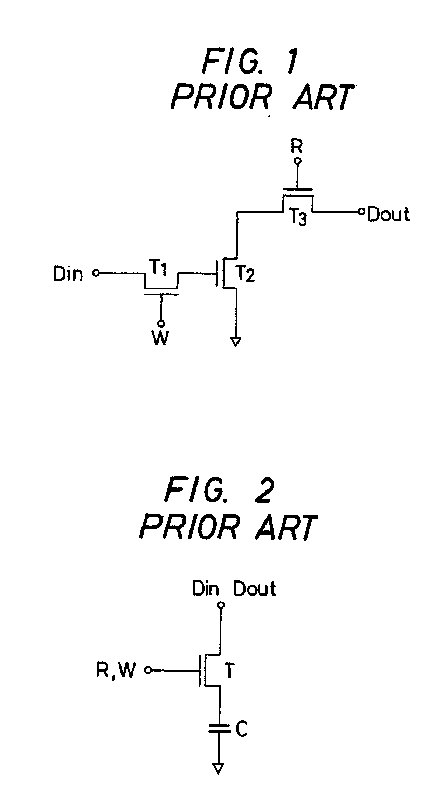

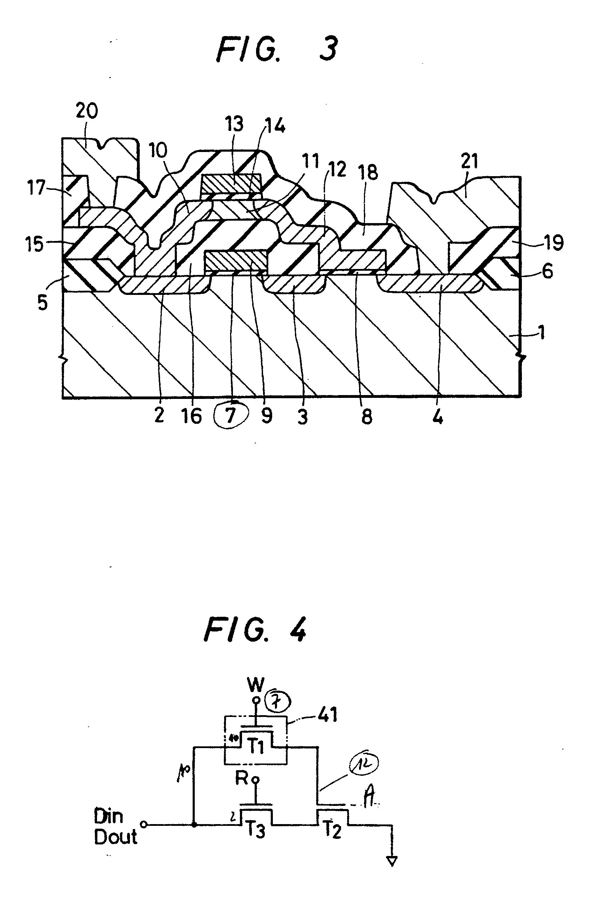

The first is a three-transistor memory cell shown in Figure 1 of the accompanying drawings, in which three transistors $T_1$, $T_2$ and $T_3$ together form one cell for storing one bit of data. Such a conventional 3 transistors memory cell is known from US-A-4084 108. The first part of claim 1, illustrated in Fig. 4, is known from said US-A-4084 108 patent specification. Transistor $T_1$ has a write function (its gate receiving a write address W). Transistor $T_3$ has a read-out function (its gate receiving a read address R) and transistor $T_2$ has an amplification function. Data are stored in the form of electric charge at the diffusion layer capacitance of transistor $T_1$ and the gate capacitance of transistor $T_2$. This charge can be maintained by periodic refreshing. The characteristic feature of this cell is that non-destructive read-out of data is possible (the input terminal for data input being shown at Din and the output terminal for data output being shown at Dout. The cell itself provides an amplification function. However, the most crucial problem with this cell is that the cell area is relatively large because of the three-transistor/cell construction. Therefore, this type of cell has few commercial applications for products having a memory capacity greater than 4K bits.

In place of the cell of the kind described above, the one-transistor/one-capacitor memory cell shown in Figure 2 of the accompanying drawings has been used for MOS DRAM having a large memory capacity. This structure is disclosed in e.g. US-A-3387286. A transistor T has the function of write/read-out address and the data is stored in a capacitor C. Periodic refreshing is necessary in the same way as in the cell shown in Figure 1. Since the structure of this cell is very simple it can be said that the cell is suitable for large scale integration. However, since read-out of the data is destructive read-out and since the cell itself does not have an amplification function, the charge-storing capacitance of capacitor C must be kept above a predetermined value in order to obtain stable operation.

The main factors that determine the lower limit of charge-storing capacitance are as follows:

(1) the ratio of charge-storing capacitance to data line capacitance ($C_S/C_D$);
(2) generation of minority carrier due to the incidence of $\alpha$ particles; and
(3) junction leakage.

Due to these three limitations, reduction of the area of the charge-storing capacitance portion has not kept pace with the progress in the technology of processing involving very fine etching in the production of IC's; hence, miniaturization has become a serious problem.

US-A-4084108 shows a 3-transistor/bit dynamic memory device wherein the gates of the reading and data storage transistors are overlapping. However, the amount of overlay is relatively small so large scale integration is not possible with this arrangement.

It is further known to increase the integration density of circuits utilizing MOS FETs by providing an assembly in which at least one transistor is stacked above another one. Examples of such three dimensional structures are known from EP-A- 0 096 734 and DE-A- 3043 913.

The present invention therefore seeks to provide a memory strucutr which eliminates, or at least ameliorates, the problems of the conventional memory cell structure described above, and which may therefore be suitable for very large scale integration.

Therefore according to the present invention there is provided a semiconductor memory comprising:

a first transistor ($T_1$) for writing having a gate electrode and source and drain region;

a second transistor ($T_2$) for amplifying having a gate electrode and source and drain regions; and

a third transistor ($T_3$) for reading, having a gate electrode, and source and drain regions;

the drain or source of the first transistor ($T_1$) being connected to the gate electrode of the second transistor ($T_2$);

the drain or source of the second transistor being connected to the source or drain of the third transistor ($T_3$); wherein at least a part of the first transistor ($T_1$) is stacked on the third transistor ($T_3$) in such a manner than an insulating film is formed on the gate electrode of the third transistor ($T_3$) and the first transistor ($T_1$) is formed as a thin film of semiconductor material on the insulating film; and

the drain or source region of the third transistor ($T_3$) is connected to the source or drain of the first transistor (T).

It is important that a memory cell structure suitable for very large scale integration satisfies two requirements:

(1) The cell area is equal to or smaller than that of the one-transistor/one-capacitor cell of the existing technology to enable fine etching.

(2) The components of the cell may be reduced as a whole, keeping pace with the progress of technology in fine etching which is expected in the future so that miniaturization techniques will continue to improve.

The present invention therefore utilizes the three-transistor structure, with its advantages non-destructive read out and amplification function, but at least a part of the first transistor is stacked on the third transistor. This reduces the area occupied by the device and so permits miniaturization.

The present invention is particularly useful in a dynamic random access memory.

Embodiments of the invention will now be described in detail, by way of example, with reference to the accompanying drawings, in which:

Figure 1 is a circuit diagram showings the conventional three-transistor memory cell which has already been described;

Figure 2 is a circuit diagram showing a conventional one-transistor/one-capacitor memory cell and has already been described;

Figure 3 is a sectional view of the present invention;

Figure 4 is a circuit diagram of the embodiment of Fig. 3;

Figures 5A and 5B are sectional views showing the production steps of the present invention; and

Figure 6 is a diagram showing the refresh characteristics of a memory cell in accordance with the present invention.

Figure 3 shows a section of a memory cell structure in accordance with the present invention. In the drawing, three transistors ($T_1$, $T_2$, $T_3$) are formed on a semiconductor substrate 1 of a first conductivity type. A gate electrode 13, an insulating film 14 and semiconductor regions 10, 12 of a second conductive type together form a first transistor $T_1$, with a write address function. A gate electrode 9, an insulating film 7 and semiconductor regions 2, 3 of the second conductive type together form a third transistor $T_3$ with a read-out address function. A gate electrode 12, an insulating film 8 and semiconductor regions 3, 4 of the second conductive type together form a second transistor $T_2$ having an amplification function. Also shown in Figure 3 are insulating films 15 to 19 and interconnections 20 and 21.

Data are stored in the form of electric charge at the gate capacitance and at the junction capacitance of region 12 which is the semiconductor region of the second conductive type (source or drain) of transistor $T_1$ and is the gate electrode of transistor $T_2$.

The device has a three-dimensional structure in which the write address transistor $T_1$ is stacked on the read-out address transistor $T_3$ via an insulating film 16. Since a three-dimensional structure is employed, the planar area of the cell may be significantly reduced, and a small cell having a planar area of, for example, about 18 $\mu m^2$, can be realized by 1.3 $\mu m$ technology. This area is smaller than that of a one-transistor/one-capacitor type memory cell.

This is because a device according to the present invention may occupy only the area necessary for two transistors, and this is less than the area necessary for one transistor and one capacitor. Thus there is a reduction on cell area which is equal to the difference between the area of a capacitor and the area of a transistor.

The greater the density of large scale integration, the greater this effect becomes because the capacitance C cannot be reduced in proportion to the increase in the density as described earlier.

Furthermore, another great advantage of the device is that since the transistor $T_1$ may be formed as a thin film of semiconductor material on the insulating film 16, the holding characteristics of the memory data can be improved. As described already, the principle of operation of this cell is that the level of the potential of the region 12 is made to correspond to "1" and "0" of the data, and this logic state is detected (read out) by conduction and cut-off of the transistor $T_2$. Since the region 12 bearing the data is formed on the insulating film 16, the effect of junction leakage and the generation of minority carrier due to $\alpha$ particles can be significantly reduced, and stored data is less likely to be destroyed. The reduction of junction leakage may be achieved by decreasing the junction area, and the reduced generation of minority carriers due to $\alpha$ particles is due to the fact that the thickness of the thin film of semiconductor may be made sufficiently less than the range of the $\alpha$ particles.

As a result, this memory cell structure makes it possible to scale down the cell as a whole, including the data storage portion, thereby keeping pace with the progress in the technology of fine etching. The device is therefore readily applicable to very large scale integration in the foreseeable future.

Figure 4 shows a circuit equivalent to the structure shown in Figure 3. As described already, the first transistor $T_1$ is formed as a thin film of semiconductor material 41 (10, 11, 12) on the insulating film (16). This is different from the memory cell shown in Figure 1 in that the data input-output lines are put together in a single line in order to make possible very large scale integration.

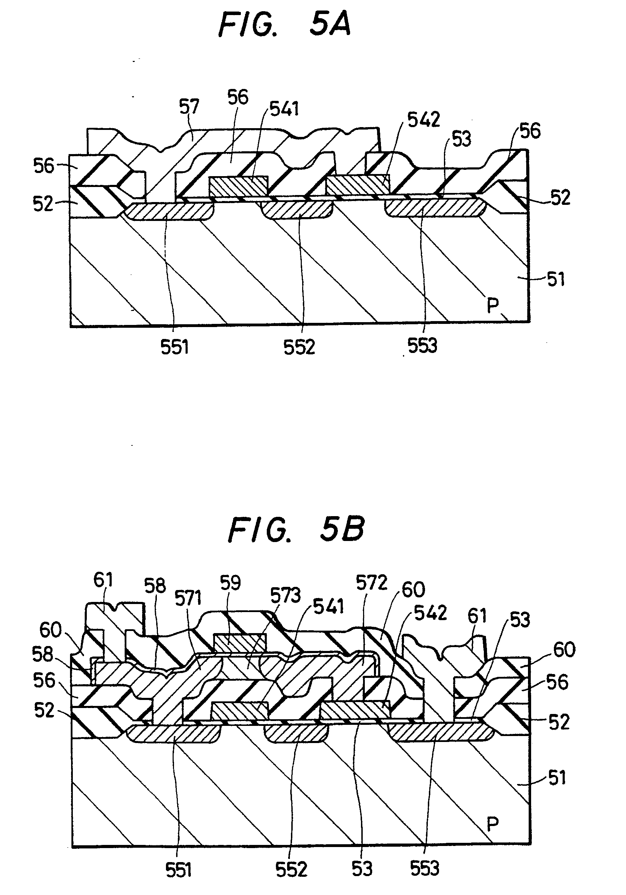

Figures 5A and 5B show the production steps of the memory cell structure in accordance with the present invention.

In Figures 5A and 5B, three transistors are formed on a semiconductor substrate 51, which is a silicon wafer having a resistivity of 10 Ohms.cm and a P-type (100) plane. A region for isolation of a thick oxide film 52 is formed on the substrate 51 by local oxidation of silicon (LOCOS), and a gate oxide film 53 is then formed in an active region. The oxide film of the region for isolation is e.g. 500 nm thick while the gate oxide film is e.g. 20 nm thick.

Boron (B) ions are implanted through the gate oxide film 53 in order to control a gate threshold voltage, and then a polycrystalline silicon film is deposited by chemical vapour deposition (CVD). The polycrystalline silicon film is subsequently patterned to form two gate electrodes 541 and 542. Boron ion implantation is carried out at an acceleration energy of e.g. 60 KeV in a dose of e.g. 1.5 $\times$ $10^{12}$ ions/cm². This provides a threshold voltage of about 1 V. The polycrystalline silicon film is e.g. 310 nm thick, while the gate length after patterning is e.g. 1.3 $\mu$m. Next, arsenic (As) ions are implanted using the gate electrodes 541 and 542 as a mask, thereby forming n-type dopant diffusion regions 551, 552 and 553 that serve as the source and drain regions of transistors (the second and third transistors). Ion implantation is carried out at an acceleration energy of e.g. 80 KeV in a dose of e.g. 5 $\times$ $10^{15}$ ions/cm².

A phosphosilicate glass film 56 is then deposited by CVD to form an insulating film. After contact holes are etched on the $n^+$-type dopant diffusion region 551 and on the gate electrode 542, a polycrystalline silicon film is again deposited by CVD. The phosphosilicate glass film is e.g. 0.4 $\mu$m thick, and the polycrystalline silicon film is e.g. 0.2 $\mu$m thick. The polycrystalline silicon film is irradiated with laser light, and the film as a whole is crystallized using the contact portion with the $n^+$-type dopant diffusion layer 551 as the seed, and is patterned to form a single crystal silicon thin film 57 that connects the $n^+$-type dopant diffusion region 551 to the gate electrode 542.

The silicon on sapphire (SOS) or silicon on insulator (SOI) techniques may be used as the method of forming the single crystal on the insulating film. This is disclosed in e.g. US-A-3484662.

After a gate oxide film 58 is formed on the surface of the single crystal silicon thin film 57 by thermal oxidation, boron (B) ions are implanted to control the threshold voltage of a transistor (the first transistor) to be formed in the silicon thin film 57. The gate oxide film is e.g. 20 nm thick. Ion implantation is carried out at an acceleration energy of e.g. 60 KeV at a dosage of e.g. 1.5 $\times$ $10^{12}$ ions/cm². This provides a threshold voltage of about 1 V. Thereafter, a polycrystalline silicon film is deposited by CVD, and is patterned to form a gate electrode 59. Arsenic (As) ions are implanted using the gate electrode 59 as the mask to form an $n^+$-type dopant diffusion regions 571 and 572 that serve as the source and drain of the first transistor. The polycrystalline silicon film is e.g. 310 nm thick, and the gate length after patterning is e.g. 1.3 $\mu$m. Arsenic ion implantation is carried out at an implantation energy of e.g. 80 KeV at a dosage of e.g. 5 $\times$ $10^{15}$ ions/cm².

Finally, high temperature annealing is carried out in an $N_2$ ambient atmosphere to activate the ions that have been introduced by ion implantation. Thereafter, an insulating film consisting of phosphosilicate glass 60, contact holes and Aℓ interconnections 61 are formed to complete the production process. High temperature annealing in the $N_2$ ambient atmosphere is carried out at e.g. 950°C for 30 minutes. As a result, the junction depth of the $n^+$-type dopant diffusion regions is about 0.25 $\mu$m and is greater than the thickness 0.2 $\mu$m of the single crystal silicon film 57, so that the junction area contributing to junction leakage of the $n^+$-type dopant diffusion region 572 may be significantly reduced.

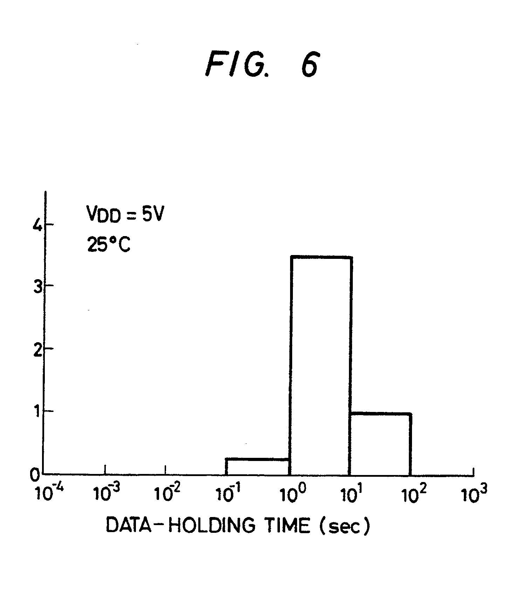

When a memory cell of this embodiment with a 1.3 $\mu$m gate is produced, the production steps for which are as described above, is integrated in 1K bit array and is subjected to an operation test, it has been confirmed that the operating voltage is within the range of from 2.5 V to 7.0 V, the production yield is high and the operation of the array stable. When the data holding time is evaluated, excellent refresh characteristics such as shown in Figure 6 can be obtained.

Figure 6 is a histogram of the data holding time. The operation conditions for a data holding time of at least $10^{-1}$ second are a power source voltage of 5 V and an ambient temperature of 25°C, the characteristics being favourably comparable to those of prior art cells.

As described above, the present invention enables the fabrication of a random access memory cell structure having a cell area smaller than that of a one-transistor/one-capacitor type memory cell, which is free, in principle, from any problem when further miniaturising the memory cell as a whole with the future progress of technology for fine etching, and which is suitable for very large scale integration. A 16M-bit memory chip will become available if technology of a 0.5 $\mu$m level can be employed.

**Claims**

1. A semiconductor memory comprising:

a first transistor ($T_1$) for writing having a gate electrode (13) and source and drain region (10,12);

a second transistor ($T_2$) for amplifying having a gate electrode (2) and source and drain regions (3,4); and

a third transistor ($T_3$) for reading, having a gate electrode, and source and drain regions (2,3);

the drain or source (10,12) of the first transistor ($T_1$) being connected to the gate electrode (2) of the second transistor ($T_2$);

the drain or source (3,4) of the second transistor being connected to the source or drain (2,3) of the third transistor (T₃);

the drain or source region (2,3) of the third transistor (T3) is connected to the source or drain of the first transistor (T)

characterised in that:

at least a part of the first transistor (T₁) is stacked on the third transistor (T₃) in such a manner than an insulating film (16) is formed on the gate electrode of the third transistor (T₃) and the first transistor (T₁) is formed as a thin film of semiconductor material (16) on the insulating film (16).

2. A semiconductor memory according to claim 1 wherein the region formed by connecting the source or drain of said first transistor to said source or drain of said third transistor (T₃) is used as a data input/output portion, and said source or drain of said second transistor (T₂) is connected to a reference potential.

3. A semiconductor memory according to claim 1 or claim 2, wherein the drain or source (12) of said first transistor (T₁) and the gate electrode (12) of said second transistor (T₂) are in the same semiconductor layer (12).

4. A semiconductor memory according to claim 1 or claim 2, wherein the drain or source (572) of said first transistor (T₁) and the gate electrode (542) of said second transistor (T₂) are in different layers.

5. A semiconductor memory according to any one of claims 1 to 4, wherein the drain or source (3,552) of said second transistor (T₂) and the source or drain (3,552) of said third transistor (T₃) are the same semiconductor region (3,552).

6. A semiconductor memory according to any one of the preceding claims, wherein the first, second and third transistors (T₁,T₂,T₃) are provided on a semiconductor substrate (1,51) and each of these transistors (T₁,T₂,T₃) has a gate insulating film (7,8,14,53,58).

7. A semiconductor memory according to claim 6, wherein the gate insulating film are a continuous insulating film.

8. A method of manufacturing the semiconductor memory according to any one of claims 1 to 7 wherein the drain or source (12) of the first transistor (T₁) is connected to the gate (8) of the second transistor (T₂) by a semiconductor layer formed in the same production step as the formation of the gate (8) of the second transistor (T₂) and the drain or source (12) of the first transistor (T₁).

9. A method according to claim 8 wherein the gate electrodes of the second and third transistors (T₂, T₃) are formed in the same production step.

**Revendications**

1. Mémoire à semiconducteurs comprenant :

un premier transistor (T₁) pour l'enregistrement, comportant une électrode de grille (13) et des régions de source et de drain (10,12);

un second transistor (T₂) pour l'amplification, comportant une électrode de grille (2) et des régions de source et de drain (3,4); et

un troisième transistor (T₃) pour la lecture, comportant une électrode de grille et des régions de source et de drain (2,3);

le drain ou la source (10,12) du premier transistor (T₁) étant raccordé à l'électrode de grille (2) du second transistor (T₂);

le drain ou la source (3,4) du second transistor étant raccordé à la source ou au drain (2,3) du troisième transistor (T₃);

la région de drain ou de source (2,3) du troisième transistor (T₃) étant raccordée à la source ou au drain du premier transistor (T);

caractérisée en ce que :

au moins une partie du premier transistor (T₁) est empilée sur le troisième transistor (T₃) de telle sorte qu'une pellicule isolante (16) est formée sur l'électrode de grille du troisième transistor (T₃), et le premier transistor (T₁) est formé sous la forme d'une pellicule mince d'un matériau semiconducteur (16) sur la pellicule isolante (16).

2. Mémoire à semiconducteurs selon la revendication 1, dans lequel la région formée par raccordement de la source ou du drain dudit premier transistor à ladite source ou audit drain dudit troisième transistor (T₃) est utilisée en tant que partie d'entrée/sortie de données, et que ladite source ou ledit drain dudit second transistor (T₂) est raccordé à un potentiel de référence.

3. Mémoire à semiconducteurs selon la revendication 1 ou 2, dans lequel le drain ou la source (12) dudit premier transistor (T₁) et l'électrode de grille (12) dudit second transistor (T₂) sont formés dans la même couche semiconductrice (12).

4. Mémoire à semiconducteurs selon la revendication 1 ou 2, dans lequel le drain ou la source (572) dudit premier transistor (T₁) et l'électrode de grille (542) dudit second transistor (T₂) sont situés dans des couches différentes.

5. Mémoire à semiconducteurs selon l'une quelconque des revendications 1 à 4, dans lequel le drain ou la source (3,552) dudit second transistor (T₂) et la source ou le drain (3,552) dudit troisième transistor (T₃) forment la même région semiconductrice (3,552).

6. Mémoire à semiconducteurs selon l'une quelconque des revendications précédentes, dans laquelle les premier, second et troisième transistors (T₁,T₂,T₃) sont prévus sur un substrat semiconducteur (1,51), et chacun de ces transistors (T₁,T₂,T₃) possède une pellicule d'isolant de grille (7,8,14,53,58).

7. Mémoire à semiconducteurs selon la revendication 6, dans laquelle la pellicule d'isolant de grille est une pellicule isolante continue.

8. Procédé pour fabriquer la mémoire à semiconducteurs selon l'une quelconque des revendications 1 à 7, selon lequel on raccorde le drain ou la source (12) du premier transistor (T₁) à la grille (8) du second transistor (T₂) au moyen d'une couche semiconductrice formée lors de la même étape de fabrication que la formation de la grille (8) du second transistor (T₂) et du drain ou de la source (12) du premier transistor (T₁).

9. Procédé selon la revendication 8, selon lequel on forme les électrodes de grille des second et troisième transistors (T₂,T₃) lors de la même étape de fabrication.

**Patentansprüche**

1. Halbleiterspeicher umfassend:

einen ersten Transistor (T₁) zum Schreiben, der eine Gateelektrode (13), einen Source- und einen Drainbereich (10, 12) aufweist;

einen zweiten Transistor (T₂) zum Verstärken, der eine Gateelektrode (2), einen Source- und einen Drainbereich (3, 4) aufweist; und

einen dritten Transistor (T₃) zum Lesen, der eine Gateelektrode, einen Source- und einen Drainbereich (2, 3) aufweist;

wobei Drain oder Source (10, 12) des ersten Transistors (T₁) mit der Gateelektrode (2) des zweiten Transistors (T₂) verbunden ist;

wobei Drain oder Source (3, 4) des zweiten Transistors mit Source oder Drain (2, 3) des dritten Transistors (T₃) verbunden ist;

wobei der Drain- oder Sourcebereich (2, 3) des dritten Transistors (T₃) mit Source oder Drain des ersten Transistors (T₁) verbunden ist;

dadurch gekennzeichnet,

daß zumindest ein Teil des ersten Transistors (T₁) so auf dem dritten Transistor (T₃) gestapelt ist, daß ein Isolierfilm (16) auf der Gateelektrode des dritten Transistors (T₃) ausgebildet und der erste Transistor (T₁) als dünner Film eines Halbleitermaterials (16) auf dem Isolierfilm (16) ausgebildet ist.

2. Halbleiterspeicher nach Anspruch 1, wobei der durch Verbinden von Source oder Drain des ersten Transistors mit Source oder Drain des dritten Transistors (T₃) gebildete Bereich als Datenein- und Ausgangsteil verwendet und Source oder Drain des zweiten Transistors (T₂) mit einem Referenzpotential verbunden ist.

3. Halbleiterspeicher nach Anspruch 1 oder 2, wobei sich Drain oder Source (12) des ersten Transistors (T₁) und die Gateelektrode (12) des zweiten Transistors (T₂) in der gleichen Halbleiterschicht (12) befinden.

4. Halbleiterspeicher nach Anspruch 1 oder 2, wobei sich Drain oder Source (572) des ersten Transistors (T₁) und die Gateelektrode (542) des zweiten Transistors (T₂) in verschiedenen Schichten befinden.

5. Halbleiterspeicher nach einem der Ansprüche 1 bis 4, wobei sich Drain oder Source (3, 552) des zweiten Transistors (T₂) und Source oder Drain (3, 552) des dritten Transistors (T₃) im gleichen Halbleiterbereich (3, 552) befinden.

6. Halbleiterspeicher nach einem der vorangehenden Ansprüche, wobei der erste, der zweite und der dritte Transistor (T₁, T₂, T₃) auf einem Halbleitersubstrat (1, 51) vorgesehen sind und jeder dieser Transistoren (T₁, T₂, T₃) einen Gateisolierfilm (7, 8, 14, 53, 58) aufweist.

7. Halbleiterspeicher nach Anspruch 6, wobei der Gateisolierfilm ein durchgehender Isolierfilm ist.

8. Verfahren zur Herstellung des Halbleiterspeichers nach einem der Ansprüche 1 bis 7, wobei Drain oder Source (12) des ersten Transistors (T₁) mit dem Gate (8) des zweiten Transistors (T₂) durch eine Halbleiterschicht verbunden ist, die im gleichen Produktionsschritt wie das Gate (8) des zweiten Transistors (T₂) und das Drain oder Source (12) des ersten Transistors (T) ausgebildet wird.

9. Verfahren nach Anspruch 8, wobei die Gateelektroden des zweiten und dritten Transistors (T₂, T₃ ) im gleichen Produktionsschritt gebildet werden.

# FIG. 1
# PRIOR ART

R

Din

T1

W

T2

T3

Dout

# FIG. 2
# PRIOR ART

Din Dout

R,W

T

C

# FIG. 3

# FIG. 4

FIG. 5A

FIG. 5B

# FIG. 6

VDD = 5V
25°C

DATA−HOLDING TIME (sec)